# DEMANDE DE BREVET EUROPEEN

(11) **EP 2 072 457 A1**
(43) Date de publication de la demande: **24.06.2009**
(21) Numéro de dépôt: 08354095.5
(22) Date de dépôt: 18.12.2008
(51) Int. Cl.: B82B 3/00, H01L 21/768, H01L 23/532

(54) **Procédé de réalisation d'une connexion électrique, à base de nanotubes, entre deux surfaces en regard**

(30) Priorité: 20.12.2007 FR 0708956
(71) Demandeur: Commissariat à l'Energie Atomique, 75015 Paris (FR)
(72) Inventeur: Louis, Didier, 38500 Coublevie (FR)
(74) Mandataire: Jouvray, Marie-Andrée

(57) **Abrégé**

Des surfaces, en regard, en matériau semi-conducteur sont formées puis transformées en semi-conducteur poreux. Le semi-conducteur poreux est ensuite transformé en matériau métallique poreux (7) par siliciuration. Le matériau métallique poreux sert ensuite de catalyseur à la croissance des nanotubes (8) de carbone qui connectent électriquement les surface en regard, en matériau métallique poreux (7).

## Description

### Domaine technique de l'invention

L'invention est relative à un procédé de réalisation d'une connexion électrique entre deux surfaces en regard, au moyen de nanotubes de carbone, le procédé comportant la formation desdites surfaces en matériau catalyseur et la croissance des nanotubes depuis lesdites surfaces.

### État de la technique

Les nanotubes de carbone font actuellement l'objet d'un important effort de recherche car leur structure cylindrique monoatomique leur confère des propriétés exceptionnelles à l'échelle nanométrique. Pour supporter les contraintes imposées par la réduction des dimensions et une complexification des paramètres d'intégration, l'utilisation des nanotubes de carbone comme fils nanométriques métalliques pour les connexions électriques a été envisagée.

Cependant, pour rivaliser avec des interconnexions en cuivre, il est nécessaire d'atteindre une densité de 10¹² nanotubes/cm². Une telle densité ne peut être atteinte qu'en forçant la localisation des nanotubes, c'est-à-dire en forçant la croissance de nanotubes ayant un diamètre faible et proches les uns des autres. De manière classique, le diamètre des nanotubes de carbone est compris entre 5 et 15nm, typiquement 8nm pour des densités qui sont de l'ordre de 5.10¹² nanotubes/cm².

De manière conventionnelle, la croissance des nanotubes de carbone est réalisée à partir d'une couche continue en matériau catalyseur qui est déposée et structurée sur un substrat. Cependant, la croissance de nanotubes depuis une couche est chaotique et il est difficile d'atteindre une densité suffisante en nanotubes. En effet, la surface disponible étant importante, la majorité des nanotubes présente un diamètres et une répartition qui est incompatible avec la densité recherchée.

Pour augmenter la densité de nanotubes, une autre approche consiste à recuire une couche en matériau catalyseur de type Cobalt, Nickel ou Fer pour former un réseau d'agrégats de petite taille sur le substrat ou alors de déposer directement ces agrégats. La taille des agrégats détermine alors la taille des nanotubes. Cependant, cette technique ne permet pas de réaliser une densité suffisante avec des agrégats de petite taille pour obtenir une densité en nanotubes qui soit suffisante pour rivaliser avec les matériaux métalliques actuels.

### Objet de l'invention

L'invention a pour objet un procédé de réalisation d'une connexion électrique à base de nanotubes qui soit facile à mettre en oeuvre et qui présente une densité en nanotubes élevée.

Le procédé selon l'invention est caractérisé par les revendications annexées et plus particulièrement par le fait que le matériau catalyseur est un matériau métallique poreux.

L'invention a également pour objet un circuit intégré comportant une telle connexion et caractérisé en ce que les surfaces en regard sont en matériau métallique poreux et disposées perpendiculairement à une surface d'un substrat.

### Description sommaire des dessins

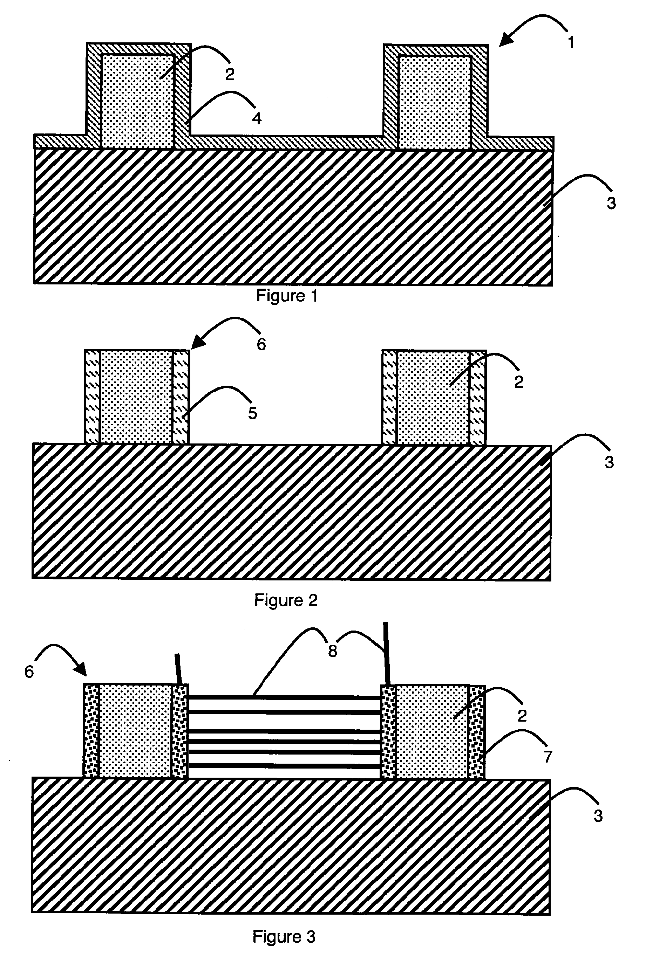

D'autres avantages et caractéristiques ressortiront plus clairement de la description qui va suivre d'un mode particulier de réalisation de l'invention donné à titre d'exemple non limitatif et représenté aux dessins annexés, dans lequel les figures 1 à 5 représentent, en coupe, de manière schématique, les étapes successives d'un mode de réalisation particulier du procédé selon l'invention.

### Description d'un mode de réalisation préférentiel de l'invention

Comme illustré à la figure 1, dans un circuit intégré, des motifs 1 en matériau diélectrique 2 sont formés sur un substrat 3, qui peut être en silicium. Le substrat 3 peut comporter des puces microélectroniques, finalisées ou non, et être recouvert par une couche d'encapsulation ou un niveau d'interconnexion métallique. La couche formant la surface supérieure du substrat 3 est avantageusement choisie de façon à permettre une structuration sélective des motifs 1 en matériau diélectrique 2. Le matériau diélectrique 2 est un matériau classique de l'industrie microélectronique, par exemple un matériau à base d'oxyde de silicium, déposé par dépôt chimique en phase vapeur, dépôt chimique en phase vapeur assisté par plasma ou à la tournette. Le matériau diélectrique peut également être à base de nitrure de silicium. Les motifs 1 formés sur le substrat 3 ont, par exemple, la forme de bandes ou de piliers.

Une couche en matériau semi-conducteur 4, par exemple en silicium ou en un alliage de silicium-germanium, est déposée de manière non sélective sur le substrat 3 et les motifs 1. Le dépôt est réalisé de manière conventionnelle, par exemple par dépôt chimique en phase vapeur ou par dépôt chimique en phase vapeur assisté par plasma. Le matériau semi-conducteur 4 forme alors un film continu. Le matériau semi-conducteur 4 peut être intrinsèque ou dopé, amorphe ou polycristallin. Le dopage du matériau semi-conducteur 4 est réalisé de manière conventionnelle, par exemple réalisé avec du bore. L'épaisseur de la couche 4 est typiquement comprise entre 10 et 100 nm, mais elle peut être également plus épaisse.

La couche en matériau semi-conducteur 4 est ensuite soumise à une attaque électrochimique, par exemple une électrolyse, dans un bain d'acide fluorhydrique afin de la rendre poreuse. La couche en matériau semi-conducteur 4 se transforme ainsi en une couche en matériau semi-conducteur poreux 5. Lorsque la couche 4 est en silicium, celui-ci est transformé en silicium poreux. La densité de pores contenus dans la couche en matériau semi-conducteur poreux 5 dépend de la nature du matériau semi-conducteur 4 déposé (cristallinité, dopage...) et des conditions de l'attaque électrochimique (densité de courant, concentration en acide fluorhydrique, température...).

La couche en matériau semi-conducteur poreux 5 est ensuite structurée de manière classique, de préférence par gravure plasma pour former des espaceurs 6 qui sont situés uniquement sur les bords latéraux des motifs 1 en matériau diélectrique 2. Les espaceurs 6 forment alors des parois verticales en matériau semi-conducteur poreux 5, perpendiculaire au substrat 3, comme illustré à la figure 2.

Un métal est déposé, de manière classique, sur l'ensemble (substrat 3 et motifs 2), par exemple de manière non sélective. Il recouvre donc la couche en matériau semi-conducteur poreux 5. Un traitement thermique, de préférence à une température inférieure à 400°C, est alors réalisé pour déclencher une réaction entre le métal et matériau semi-conducteur poreux 5 et former un matériau métallique poreux 7. Le métal utilisé pour réaliser le matériau métallique poreux 7 est de préférence choisi parmi Co, Ni, Pt et Fe. Dans ce cas, à partir de silicium poreux, le matériau métallique poreux obtenu est un siliciure tel que CoSi₂, NiSi, PtSi ou FeSi. Le métal qui n'a pas réagi, notamment avec le matériau semi-conducteur est ensuite éliminé de manière classique, par exemple par retrait par voie humide.

Comme illustré aux figures 2 et 3, les parois verticales en matériau semi-conducteur poreux 5, par exemple en silicium, sont ainsi transformées en parois verticales en matériau métallique poreux 7. Lors de la réaction entre le métal et le matériau semi-conducteur poreux, une partie des pores ont été bouchées. Cependant, il reste encore des pores et des espaces libres à la surface des espaceurs. La taille des pores est typiquement comprise entre 2 et 100nm avec une densité qui est comprise entre 10⁷ et 10¹² pores/cm².

Le matériau métallique poreux 7 sert ensuite de matériau catalyseur pour la croissance de nanotubes 8 entre les parois verticales adjacentes. Cette croissance est réalisée (figure 3), par exemple par dépôt chimique en phase vapeur, essentiellement depuis une surface verticale jusqu'à la surface verticale en regard. Les nanotubes 8, électriquement conducteurs, croissent à partir du matériau métallique poreux 7 depuis des zones situées entre les pores restant à la surface du matériau 7. Le nombre et le diamètre des nanotubes sont déterminés par la densité de pores et par les dimensions des zones de surface se situant entre les pores. La majorité des nanotubes 8 a ainsi une croissance horizontale. Le procédé de croissance des nanotubes peut être réalisé par dépôt chimique en phase vapeur ou par dépôt chimique en phase vapeur assisté par plasma. La température de dépôt est typiquement de l'ordre de 450-500°C avec une composition gazeuse à base d'acétylène. Il est également possible d'utiliser, par exemple de l'éthylène ou du toluène. La température de croissance des nanotubes de carbone est choisie de manière à ne pas réaliser la décomposition du matériau métallique poreux 7 formé.

Ainsi, les nanotubes 8, sensiblement horizontaux, connectent deux surfaces verticales, en regard, disposées sur le substrat 3. L'utilisation d'un matériau catalyseur poreux permet ainsi d'obtenir une grande densité de nanotubes horizontaux et, en conséquence, d'augmenter la densité du courant pouvant passer dans la connexion électrique ainsi formée.

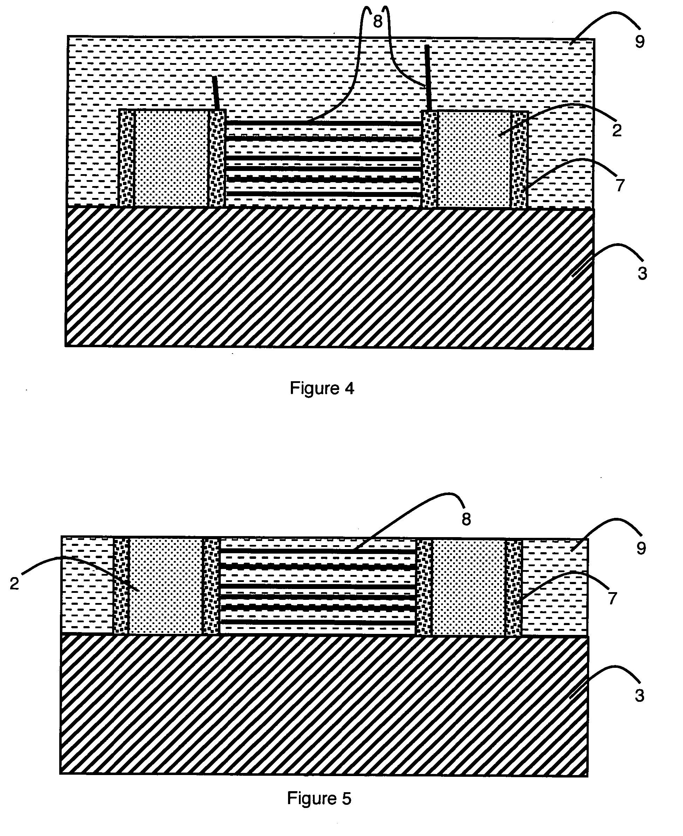

Une couche d'enrobage 9 est ensuite déposée sur l'ensemble (substrat 3, motifs 1 et nanotubes 8). La couche d'enrobage 9, avantageusement en matériau diélectrique, remplit au moins partiellement la cavité comprise entre les surfaces verticales en regard, à l'intérieur de laquelle se trouvent les nanotubes 8. Sur la figure 4, les nanotubes 8 et les motifs 1 sont totalement enrobés dans la couche 9.

Avantageusement, une étape de polissage, par exemple mécano-chimique, est réalisée pour aplanir la couche d'enrobage 9 et éliminer les nanotubes 8 qui font saillis vers le haut à partir des motifs 1 en matériau diélectrique 2. Une fois la structure aplanie, une nouvelle couche en matériau diélectrique peut être déposée pour finaliser la structure ou pour permettre la réalisation d'un autre niveau d'interconnexion dans le circuit intégré.

Le semi-conducteur est avantageusement du silicium, rendu poreux par électrolyse, puis siliciuré pour constituer un siliciure poreux servant de catalyseur. L'invention s'applique néanmoins à tout semi-conducteur pouvant être transformé en matériau métallique poreux susceptible de servir de catalyseur pour la croissance de nanotubes, en particulier de nanotubes de carbone.

## Revendications

1. Procédé de réalisation d'une connexion électrique entre deux surfaces en regard, au moyen de nanotubes (8) de carbone, le procédé comportant la formation desdites surfaces en matériau catalyseur et la croissance des nanotubes (8) depuis lesdites surfaces, procédé **caractérisé en ce que** le matériau catalyseur est un matériau métallique poreux (7) obtenu par réaction d'une couche de semi-conducteur poreux (5) et d'un métal.

2. Procédé selon la revendication 1, **caractérisé en ce que** le matériau métallique poreux (7) est un siliciure.

3. Procédé selon l'une des revendications 1 et 2, **caractérisé en ce que** le métal est choisi parmi Co, Ni, Pt et Fe.

4. Procédé selon l'une quelconque des revendications 1 à 3, **caractérisé en ce qu'**il comporte successivement sur un substrat (3) :
- la formation de motifs (1) en matériau diélectrique (2),
- le dépôt d'une couche en matériau semi-conducteur (4),
- la transformation dudit matériau semi-conducteur en semi-conducteur poreux (5),
- la formation, par gravure de la couche en semi-conducteur poreux (5), d'au moins deux espaceurs (6) perpendiculaires au substrat (3) constituant lesdites surfaces en regard,
- la siliciuration des espaceurs (6) en semi-conducteur poreux (5) au moyen d'un métal,
- la croissance des nanotubes (8) entre les espaceurs (6), parallèlement au substrat (3).
